# EUROPEAN PATENT APPLICATION

(11) **EP 1 763 082 A2**
(43) Date of publication of application: **14.03.2007**
(21) Application number: 06254756.7
(22) Date of filing: 13.09.2006
(51) Int. Cl.: H01L 27/32, H01L 51/52

(54) **Flat panel display and organic light emitting display**

(30) Priority: 13.09.2005 KR 20050085412
(71) Applicant: Samsung SDI Co., Ltd., Suwon-city, Kyungki-do 442-390 (KR)
(72) Inventor: Shin, Hyun Soo Legal & IP Team, Samsung SDI Co.,, Yongin-si Gyeonggi-do (KR); Jeong, Jae Kyeong c/o Samsung SDI Co.Ltd., Gyeonggi-do (KR); Mo, Yeon Gon c/o Samsung SDI Co., Ltd., Gyeonggi-do (KR); Jin, Dong Un c/o Samsung SDI Co., LTD., Gyeonggi-do (KR)
(74) Representative: Mounteney, Simon James

(57) **Abstract**

A flat panel display and an organic light emitting display, each comprising a transparent two-sided emission panel and a controlling unit on the lower portion of the emission panel, enabling it to display a double-sided or single-sided image. The controlling unit controls an array of liquid crystal layers depending on a voltage applied thereto and allows transmission of light with the aid of a first polarizing member and a second polarizing member.

## Description

### BACKGROUND

### 1. Field of the Invention

The present invention relates to a flat panel display and an organic light emitting display. Particularly, but not exclusively, the invention relates to a flat panel display and an organic light emitting display which are selectively able to display an image on single or double sides under manual or automatic direction.

### 2. Description of the Related Art

Demands on personal computers (PC), car navigation systems, personal digital assistants, information communication devices and the like have recently increased with the advent of an information oriented society. Consequently, such products are now expected to offer high visibility, a wide viewing angle, and a high response speed. Flat panel displays (FPD) typically meet these criteria and are therefore favoured as next generation displays.

To-date thin film transistors (TFT) have widely been used as switching devices that operate each pixel in a display device such as an organic light emitting display (OLED) or a liquid crystal display (LCD). Therefore, significant attention has been paid to the fabrication ofTFTs, a FPDs using more effective TFTs and related driving methods.

An organic light emitting display as used in a conventional FPD will now be described in detail with reference to the attached drawings.

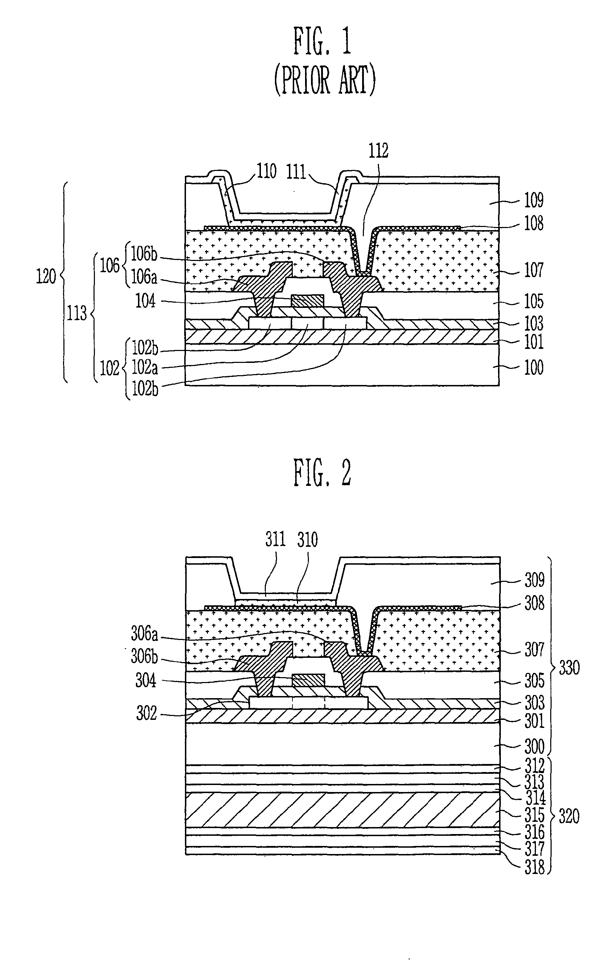

FIG. 1 is a schematic sectional view of a conventional organic light emitting display.

Referring to FIG. 1, a conventional organic light emitting display 120 comprises: a substrate 100; and a buffer layer 101 formed on the substrate 100. A semiconductor layer 102 including an active layer 102a and ohmic contact layers 102b is formed on a region of the buffer layer 101. A gate insulating layer 103 is formed on the semiconductor layer 102. A gate electrode 104 is formed on a region of the gate insulating layer 103 and an interlayer insulating layer 105 is formed on the gate electrode 104. Source and drain electrodes 106a and 106b are formed on a region of the interlayer insulating layer 105 and configured to be connected to exposed regions of the ohmic contact layers 102b. A planarization layer 107 is formed on the source and drain electrodes 106a and 106b. A first electrode layer 108 formed on a region of the planarization layer 107 is connected to exposed regions of the source and drain electrodes 106a and 106b. A pixel defining layer 109 including an aperture that allows exposure of at least a region of the first electrode layer 108 is formed in the first electrode layer 108 and the planarization layer 107. An emission layer 110 is formed on the aperture and a second electrode layer 111 is formed on the emission layer 110 and the pixel defining layer 109. The source and drain electrodes 106a, 106b and the semiconductor layer 102 together define a TFT 113, which acts as a switching device for the organic light emitting display.

The semiconductor layer 102, the gate electrode 104 and the source and drain electrodes 106a and 106b are formed of an opaque material, with the semiconductor layer 102 being formed of amorphous silicon or polysilicon. Since these materials are not transparent, there are limitations on increasing the width of the channel region, primarily due to the characteristics of the opaque semiconductor layer 102. Consequently, large current does not flow into the channel region and a high voltage must be applied to the TFT 113. A result of this is that the organic light emitting display deteriorates and power consumption increases. In addition, it is not possible to provide double-sided emission or even front emission when needed or to the extent required by ambient lighting conditions.

### SUMMARY OF THE INVENTION

The invention sets out to solve the above problems and accordingly provides an FPD as set out in claim 1. Prefered features of this aspect of the invention are set out in claims 2 to 4. A second aspect of the invention provides an OLED as set out in claim 5. Preferred features of this aspect of the inention are set out in claims 6 to 16.

### BRIEF DESCRIPTION OF THE DRAWINGS

FIG. 1 is a schematic sectional view illustrating a conventional organic light emitting display (OLED);

FIG. 2 is a schematic sectional view illustrating an organic light emitting display according to a first embodiment of the present invention;

FIG. 3 is a schematic sectional view illustrating an organic light emitting display according to a second embodiment of the present invention;

FIG. 4 is a schematic sectional view illustrating the organic light emitting display of FIG. 3 in a state in which a voltage is applied to its first electrodes;

FIG. 5 is a schematic sectional view illustrating the organic light emitting display of FIG. 3 in a state in which a voltage is applied to its second electrodes;

FIG. 6 is a schematic sectional view illustrating an organic light emitting display according to a third embodiment of the invention in a state in which a voltage is not applied thereto;

FIG. 7 is a schematic sectional view illustrating the organic light emitting display of FIG. 6 in a state in which a predetermined voltage is applied thereto; and

FIG. 8 is a schematic sectional view illustrating the organic light emitting display of FIG. 6 in a state in which a predetermined voltage is applied thereto.

### DETAILED DESCRITPION OF THE PREFERRED EMBODIMENTS

Hereinafter, a flat panel display (FPD) and a method of driving the same according to preferred embodiments of the present invention will be described with reference to the attached drawings.

Throughout this document, the word 'transparent' comprises the meaning of 'transparent or transmissive'. Also, according to the present invention, for convenience's sake, a controlling unit connected to an emission panel using an organic light emitting display (OLED) is described. However, the present invention can be applied to a liquid crystal display (LCD), a field emission display (FED), a plasma display panel (PDP), an electro luminescent display (ELD), and a vacuum fluorescent display (VFD).

FIG. 2 is a schematic sectional view illustrating an organic light emitting display according to a first embodiment of the present invention.

Referring to FIG. 2, the organic light emitting display comprises: a display unit 330 including at least one organic light emitting diode and a thin film transistor formed on a region of a first transparent substrate 300; and a controlling unit 320 formed on the lower portion of the display unit 330 to control intensity of light of the display unit 330.

Hereinafter, the controlling unit 320 will be described in more detail.

A first substrate 313 and a second substrate 317 of the controlling unit 320 are arranged to be opposite to each other, a first transparent electrode 314 and a second transparent electrode 316 are formed on the inner sides of the first substrate 313 and the second substrate 317, respectively, a liquid crystal layer 315, which is a light shielding layer, is interposed between the first transparent electrode 314 and the second transparent electrode 316, and a first polarizing plate 312 and a second polarizing plate 318 are positioned on respective outer sides of the first substrate 313 and the second substrate 317.

Also, the controlling unit 320 further comprises a controller (not shown) applying voltage to the first transparent electrode 314 and the second transparent electrode 316, and the controller (not shown) can manually be driven or automatically controlled by a photosensing.

The liquid crystal layer 315 can shield or transmit light, as the voltage applied from the controller (not shown) is applied to the first transparent electrode 314 and the second transparent electrode 316.

For example, when the controlling unit is a twisted nematic (TN), the controlling unit varies an array of liquid crystal depending on the voltage applied to the first transparent electrode and the second transparent electrode. In other words, the liquid crystal layer 315 assumes a 90° twist when the voltage is off, and the liquid crystal layer 315 is vertically aligned relative to the substrate when the voltage is on.

Accordingly, when the voltage is off, only a first linear polarization from a light source, which coincides with a first polarization axis, passes through a first polarizing plate 312; the first linear polarization passes through the 90° twisted liquid crystal layer 315 so that it becomes a second linear polarization, which is a polarization state that coincides with a second transmitting axis; and the second linear polarization coincides with the transmitting axis of a second polarizing plate 318 and passes through a substrate as it is so that it is displayed as white on a screen.

When the voltage is on, only a first linear polarization from a light source, which coincides with a first polarization axis, passes through a first polarizing plate 312; and although the first linear polarization passes through the liquid crystal layer 315 vertically arranged to a substrate as it is, the first linear polarization is shielded by a second polarizing plate 318 so that it is displayed as black on a screen.

As described above, the first polarizing plate 312 and the second polarizing plate 318 in the controlling unit 320 can display gray shades occurring between black and white by controlling the intensity of transmitted light depending on the degree of revolution of the polarization axis while the light passes through a liquid crystal cell.

Hereinafter, the display unit 300 will be described in more detail.

The display unit 300 is formed on the controlling unit 320. The display unit 330 comprises: a substrate 300; a buffer layer 301 formed on the substrate 300; a transparent semiconductor layer 302 formed in a predetermined pattern on the buffer layer 301; a gate insulating layer 303 formed on the transparent semiconductor layer 302; a gate electrode 304 formed on the gate insulating layer 303 and patterned to corresponded with the transparent semiconductor layer 302; an interlayer insulating layer 305 formed on the gate electrode 304; a planarization layer 307 formed on source and drain electrodes 306a and 306b, which are electrically connected to the transparent semiconductor layer 302 via a contact hole formed on the gate insulating layer 303 and the interlayer insulating layer 305; a third electrode layer 308 formed on a region of the planarization layer 307 and formed to be connected to either of the source and drain electrodes 306a and 306b; a pixel defining film 309 formed on the third electrode layer 308 and having an aperture that at least partially exposes the third electrode layer 308; a emission layer 310 formed on a region of the pixel defining film 309 and the aperture; and a fourth electrode layer 311 formed on the upper portion of the emission layer 310.

The transparent substrate 300, for example, may be formed of insulating materials such as glass, plastic, sapphire, silicon or synthetic resins, etc. It is most preferable that the transparent substrate 300 is formed in a flexible thin film form.

The buffer layer 301 is formed on the substrate 300. The buffer layer 301 is formed of a nitride film, an oxide film or transparent insulating materials, etc., but is not limited thereto.

The semiconductor layer 302 is formed of wide band semiconductor substances whose band gap is 3.0eV or more and which have transparency. For example, the semiconductor layer 302 may be formed of at least one material selected from the group comprising oxides such as ZnO, ZnSnO, CdSnO, GaSnO, TlSnO, InGaZnO, CuAlO, SrCuO; and LaCuOS, nitrides such as GaN, InGaN, AlGaN, and InGaAlN; and carbides such as SiC and diamond, etc.

The gate insulating layer 303 is formed on the transparent semiconductor layer 302, and insulates the transparent semiconductor layer 302 and the gate electrode 304. The gate insulating layer 303 is formed of an oxide film, a nitride film or transparent insulating materials, etc., but is not limited thereto.

The gate electrode 304 is formed on the gate insulating layer 303 and is formed over the upper portion of the channel region (not shown) of the transparent semiconductor layer 302 in a predetermined pattern. The gate electrode 304 and the source and drain electrodes 306a and 306b are formed of metals having good conductivity and transparency, such as indium tin oxide (ITO), indium zinc oxide (IZO), and indium tin zinc oxide (ITZO) and translucent metals, etc., but are not limited thereto.

The interlayer insulating layer 305 is formed on the gate electrode 304 and the insulating substances of the interlayer insulating layer 305 are formed of the same substances as the gate insulating layer 303.

The source and drain electrodes 306 and 306b are formed on the interlayer insulating layer 305, and each are formed to be electrically connected to both sides of the transparent semiconductor layer 302 via a respective contact hole formed in the gate insulating layer 303 and the interlayer insulating layer 305. Here, the source and drain electrodes 306a and 306 are formed of the same substances as the gate electrode 304.

The planarization layer 307 is formed on the transparent thin film transistor and is formed of a nitride film, an oxide film or transparent insulating materials, etc., but is not limited thereto. A via hole formed by etching a region of the planarization layer 307 is formed in the planarization layer 307. The third electrode layer 308 is electrically connected to either of the source and drain electrodes 306a and 306b through the via hole formed on the planarization layer 307.

The pixel defining film 309 is formed on the third electrode layer 308 and has an aperture that at least partially exposes it. The emission layer 310 is formed in a region of the pixel defining layer 309 defined by the aperture, and can further include some of a hole injecting layer, a hole transporting layer, an electron injecting layer, and an electron transporting layer. The emission layer 310 emits light when holes and electrons injected from the third electrode layer 308 and the fourth electrode layer 311 are combined.

The fourth electrode layer 311 is formed on the emission layer 310 and the pixel defining film 309, and the third electrode layer and the fourth electrode layer 310 are formed of the same substances as the gate electrode 304.

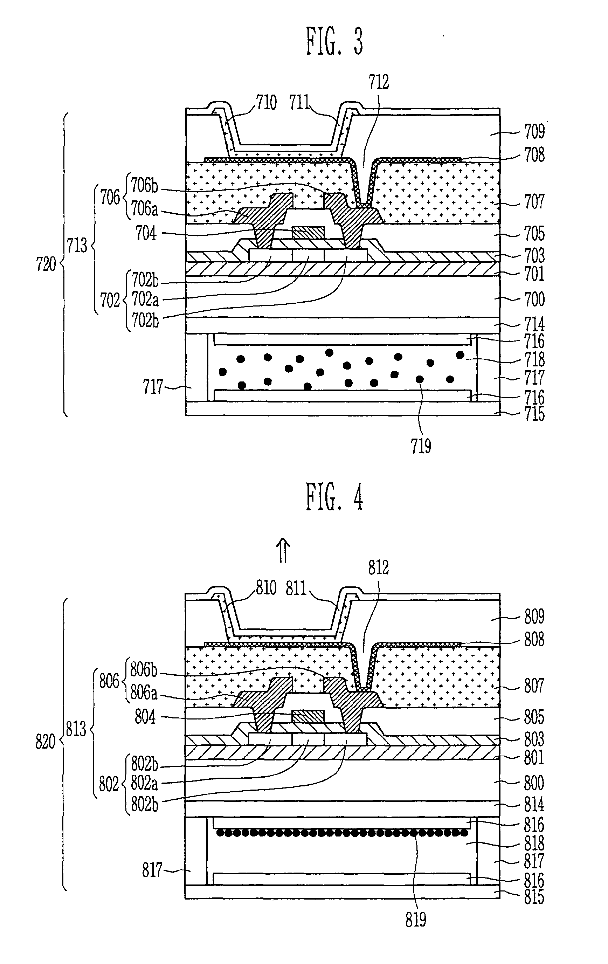

FIG. 3 is a schematic sectional view illustrating an organic light emitting display 720 according to a second embodiment of the present invention.

As shown in FIG. 3, at least one transparent thin film transistor 713 and an emission unit 710 are formed over a substrate 700.

The lower portion of the substrate 700 is attached to an electrophoretic device that acts as a controlling unit. The electrophoretic device is a non-emission type display device. According to the electrophoretic phenomenon, when an electric field is applied to a solution obtained by dispersing charged particles in a solvent, the charged particles suffering from the dispersion are naturally electrophoreticed by Coulomb forces. When the solution is contained within a capsule and an electric field is applied thereto, the particles move to produce an electrical display.

The electrophoretic device present in this embodiment includes a first transparent substrate 714 connected to one side of a transparent double-sided emission panel and a second transparent substrate 715 separated from the first transparent substrate 714 by a predetermined distance and parallel with the first transparent substrate 714. A pair of first transparent electrodes 716 are respectively mounted on the sides of the first transparent substrate 714 and the second transparent substrate 715 that face each other. A pair of second transparent electrodes 717each are perpendicularly mounted at respective ends of the first transparent substrate 714 and the second transparent substrate 715. A solvent 718, into which charged particles 719 are dispersed, serves as a light shielding layer, and is included between the first transparent substrate 714 and the second transparent substrate 715.

Either of the first transparent electrodes 716 may be entirely formed on the internal side of the first transparent substrate 714 or the second transparent substrate 715 and may be divided into a plurality of pieces.

Although not shown in the drawing, spacers may be further provided outside the second transparent electrodes 717 so that the first transparent substrate 714 and the second transparent substrate 715 are separated from each other by a predetermined distance.

The solvent 718 fills the space between the first transparent substrate 714 and the second transparent substrate 715 and charged particles 719 are dispersed into the solvent 718. The charged particles 719 are black and are formed of materials having a satisfactory charged characteristic of positive polarity or negative polarity of the solvent 718. For example, the charged particles 719 are formed of inorganic pigment, organic pigment, carbon black, or resin containing the material. The solvent has insulating properties and does not react to the charged particles and is formed of a transparent non-polar solvent, such as isoparaffin, silicon oil, xylene, or toluene.

A charge control agent, for controlling the charge of the charged particles 719 and stabilising them may be added to the solvent 718 or the charged particles 719. Succinimide, metal complex of monoazo dye, salicylic acid, and organic silicon quaternary ammonium salt, and nigrosine compound can be used as the charge control agent. A dispersion agent for preventing the charged particles 719 from being cohering may also be added to the solvent 718. Polyvalent metal salt phosphates such as calcium phosphate and magnesium phosphate; carbonates such as calcium carbonate, inorganic salt, inorganic oxide; and organic polymer materials can be used as the dispersion agent.

There are no limitations on combination between the solvent and the charged particles. However, the solvent and the charged particles are preferably combined with each other in the same ratio, in order to prevent the charged particles from sinking due to gravity.

A system controlling unit (not shown) for applying a voltage to the first transparent electrode 716 or the second transparent electrode 717 is included, so that the voltage can be selectively applied to the first transparent electrode 716 and the second transparent electrode 717 using a switch provided in the system controlling unit.

The thickness of the electrophoretic device attached under the substrate 200 is 50 to 500µm.

The solvent 718 or the charged particles 719 serve as a light shielding layer for shielding or transmitting light depending on the voltage applied to the first transparent electrode 716 and the second transparent electrode 717. Therefore, substances interposed in the first transparent electrode 716 and the second transparent electrode 717 are not limited to the solvent 718 or the charged particles 719, but any substances capable of being switch-driven by the first transparent electrode 716 and the second transparent electrode 717 can be used. Substances satisfying the conditions described above includes polymer dispersed liquid crystal (PDLC), for example.

IF PDLC is not subjected to a voltage, it is arranged in irregular directions so as to cause scattering at an interface with a medium having a different refractive index. If a liquid crystal molecule is subjected to a voltage, the PDLC becomes uniformly arranged in a regular direction. As a result, light can be shielded or transmitted by selectively applying voltage to the first transparent electrode 716 and the second transparent electrode 717.

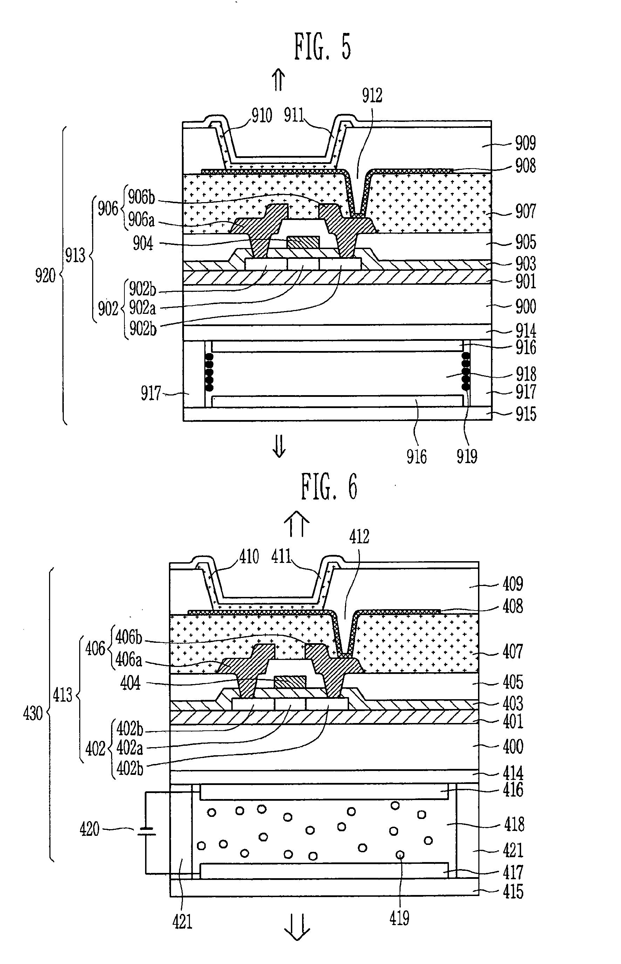

FIGs. 4 and 5 are schematic sectional views illustrating a method of driving an OLED 820 of the type illustrated in FIG. 3. For convenience's sake, a detailed description of the same elements as those of FIG. 3 will be omitted. In particular, a detailed description of the transparent TFT formed on the substrate and the material of the transparent TFT will be omitted.

In FIG. 4, a voltage is applied to the first electrode. When the charged particles 819 have positive (+) charges, a negative (-) voltage is applied to the first transparent electrode 816. When the negative (-) voltage is applied to the first transparent electrode 816, the charged particles having the positive (+) charges are adsorbed at the first transparent electrode 816. Since the charged particles 819 are black, the rear side from which light is emitted operates as a black matrix, so that the OLED 820 emits light from the front side.

When the charged particles 819 have negative (-) charges, a positive (+) voltage is applied to the first transparent electrode 816. When the positive (+) voltage is applied to the first transparent electrode 816, the charged particles 819 having the negative (-) charges are adsorbed at the first transparent electrode 816. Since the charged particles 819 are black, the rear side from which light is emitted operates as a black matrix so that the OLED 820 according to the present invention emits light from the front side.

FIG. 5 is a schematic sectional view illustrating a state in which a voltage is applied to a second electrode of an OLED 920 of the type shown in FIG.s 3 and 4. In the illustrated arrangement, the charged particles 919 have positive (+) charges and a negative (-) voltage is applied to the second transparent electrodes 917 in the form of barrier ribs that contact the first transparent substrate 914 and the second transparent substrate 915. Since a negative (-) voltage is applied to the second transparent electrodes 917, the positively charged particles 919 are adsorbed at the second transparent electrodes 916. Therefore, the rear side of the OLED becomes transparent so that the OLED 920 emits light from both sides.

When the charged particles 919 have negative (-) charges, a positive (+) voltage is applied to the second transparent electrodes 917. Since the positive (+) voltage is applied to the second transparent electrodes 917, the negatively charged particles 919 are adsorbed to the second transparent electrodes 917. Therefore, the rear side of the OLED 920 becomes transparent so that the OLED 920 emits light from both sides.

It is accordingly the case that the above embodiment of the invention is configured such that, if a voltage is selectively applied to the first transparent electrode or the second transparent electrode, it is possible to display an image on just the front side of the panel or alternatively on both sides at the user's discretion.

FIG. 6 is a schematic sectional view illustrating an organic light emitting display 430 according to a third embodiment of the present invention. In this figure, the display 430 is not being subjected to a voltage.

As shown in FIG. 6, the OLED 430 comprises a substrate 400, at least one transparent TFT 413 and an emission layer 410.

The lower portion of the substrate is provided with an electrochromic device that serves as a controlling unit. In general, electrochromism is a phenomenon reversibly causing electrolytic oxidizing and reducing reactions and reversibly causing coloring and decoloring, when voltage is applied. Electrochromic devices using the phenomenon have been used as a light intensity controller (for example, in a mirror such as an antiglare mirror or light control glass, etc.), and a brightness controlling element (such as an organic light emitting diode, etc.) and a display element (for example in a segmented number display or an electrochromic display, etc). Electrochromic devices can mainly be categorised as either a solution type or a complete solid type, depending upon the material type of their electrochromic layer.

In the electrochromic device attached to the lower portion of the substrate 400 according to the embodiment of Figure 6, the first transparent substrate 414 and the second transparent substrate 415 are arranged opposite to each other with a predetermined separation. Although not shown in the drawing, spacers may be formed between the first transparent substrate 414 and the second transparent substrate 415 to provide the required spacing between transparent substrate 414 and the second transparent substrate 415. The first transparent substrate 414 and the second transparent substrate 415 may be formed from a transparent glass substrate such as quartz, glass plate or a white board glass plate, etc, but other materials may be used. For example, The first transparent substrate 414 and the second transparent substrate 415 may be formed from an ester, such as polyethylenenaphthalate or polyethyleneterephthalate, etc.; a cellulose ester, such as polyamide, polycarbonate, or cellulose acetate, etc.; a fluoropolymer such as polyvinylidene fluoride or polytetrafluoroethylenecohexafluoro-propylene, etc.; a polyether such as polyoxymethylene, etc.; a polyolefin, such as polyether, polyacetal, polystyrene, polyethylene, polypropylene, or methylpentenepolymer, etc.; or a polyimide such as polyimideamide or polyetherimide, etc.

The first transparent electrode 416 and the second transparent electrode 417 are formed on the internal sides of the first transparent substrate 414 and the second transparent substrate 415, respectively. A film of ITO, SnO, InO, ZnO, or the like may be used as the first transparent electrode 416 and the second transparent electrode 417. The electrodes attached to the first transparent substrate 414 and the second transparent substrate 415 can be formed by known methods such as a deposition method, an ion plating method, or a sputtering method, etc.

An electrochromic layer filled with an electrolyte 418 containing a coloring agent 419, which is a light shielding layer, is formed between first transparent electrode 416 and the second transparent electrode 417. The electrolyte can be formed by dissolving, for example, a cathode compound such as a viologen derivative, etc., and an anode compound consisting of metallocene(M(C₅ G₅)₂) or its derivative, etc., with non-aqueous solvent.

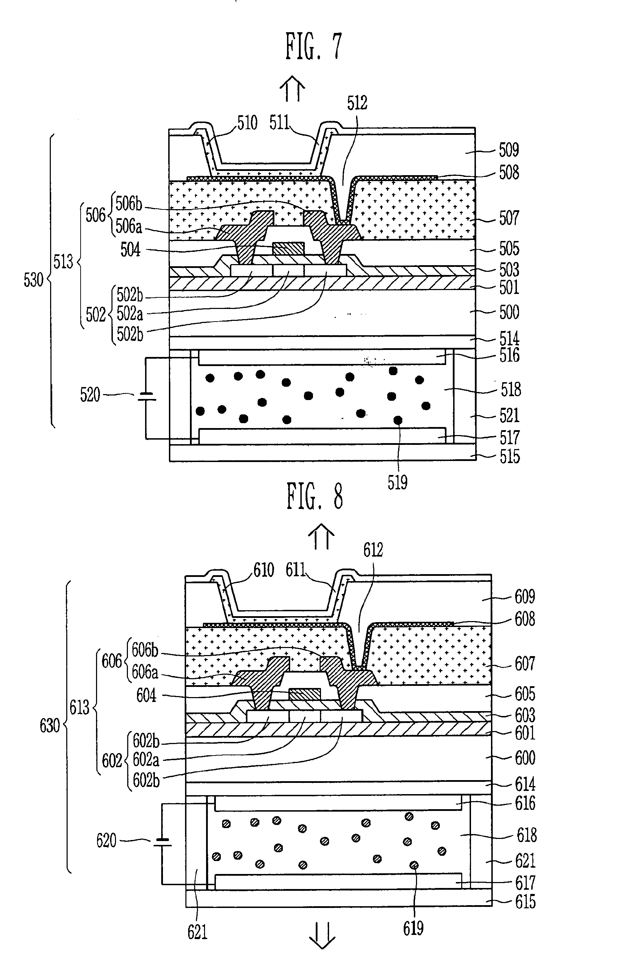

A controlling unit 420 is formed between the first transparent electrode 416 and the second transparent electrode 417. The controlling unit 420 is formed with a switch (not shown), which switches an electric conductive direction. Therefore, upon operating the switch, the first transparent electrode 416 conducts negative (-) current and the second transparent electrode 417 positive (+) current so that a chemical reaction is generated in the electrochromic layer. A detailed description of chemical reaction will be given with reference to FIGs. 7 and 8.

A member (not shown) is formed around the first transparent substrate 414 and the second transparent 415 to prevent the electrolyte 418 from leaking outside thereof and to bond the first transparent substrate 414 and the second transparent 415. The thickness between the first transparent substrate 414 and the second transparent substrate 415 is in the range of 10 to 100µm.

In this embodiment, if a voltage is not applied between the first transparent electrode 416 and the second transparent electrode 417, the electrolyte 418 containing the coloring agent 419 is transparent so that the OLED 430 according to the present invention emits light from both sides.

FIGs 7 and 8 are schematic sectional views illustrating a method of driving an OLED according to a third embodiment of the present invention. For convenience's sake, a detailed description of the same elements as those of FIG. 6 will be omitted. In particular, a detailed description of a transparent thin film transistor and materials of the transparent thin film transistor will be omitted.

Referring to FIG. 7, a predetermined voltage is applied between the first transparent electrode 516 and the second transparent electrode 517 by switching electric conductive direction using a switch (not shown) provided on the controlling unit 520. The electrolyte 518 containing the coloring agent 519 changes its own color by oxidation and reduction reactions. Elements are colored by electrochemical reaction inside the electrochromic layer.

As an example, reference will now be made to compound reaction equations of viologen. Reaction equation 1 below is a cathode compound reaction equation of a typical viologen derivative. Viologen has a transparent condition as Bipm²⁺ in its original state, but if voltage is applied to the viologen, a reduction reaction is generated, thereby changing it into a Bipm⁺ state, thereby indicating a deep black. Likewise, if an oxidation reaction is generated in the electrochromic layer, the viologen changes its color from a deep black to a transparent state.

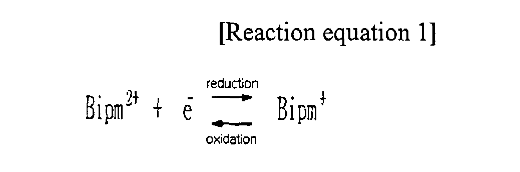

As can be seen from chemical equation 1 below, if the viologen is subjected to a predetermined voltage, the viologen reacts to change its color from a transparent state to a deep black. In chemical equation 1, each of R₁ and R₂ indicates phenyl group or alkyl group having 1 to 10 carbon atoms. Likewise, if an oxidation reaction is generated, the viologen changes its color from a deep black to a transparent state.

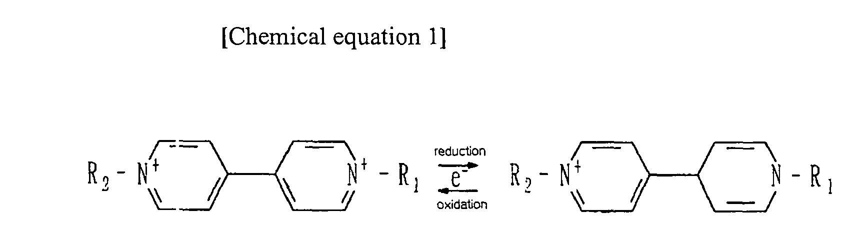

To summarize, if a predetermined voltage is applied between the first transparent electrode 516 and the second transparent electrode 517, a reduction reaction may be generated in the electrochromic layer, the electrochromic layer consequently changes its color from a transparent state to a deep black to serve as a black matrix and the organic light emitting display 530 emits light from front side. Alternatively, when an oxidation reaction is generated in the electrochromic layer, the electrochromic layer changes its color from a deep black to a transparent state so that the OLED 530 can emit light from both sides.

FIG. 8 is a schematic sectional view illustrating another state in which a predetermined voltage is applied to an organic light emitting display (630) according to the third embodiment of the present invention.

Referring to FIG. 8, voltage larger than that in FIG. 7 is applied between the first transparent electrode 616 and the second transparent electrode 617 by switching electric conductive direction using a switch (not shown) provided on the controlling unit 620.

A reaction equation 2 is a cathode compound reaction equation of a viologen derivative such as can be used in the electrochromic layer 618. The viologen applied with a predetermined voltage enters a Bipm⁺ state, to indicate a deep black, but if a voltage larger than the predetermined voltage is applied to the viologen, the viologen changes its color to a light black. Likewise, if an oxidation reaction is initiated, the viologen changes its color from a deep black to a light black.

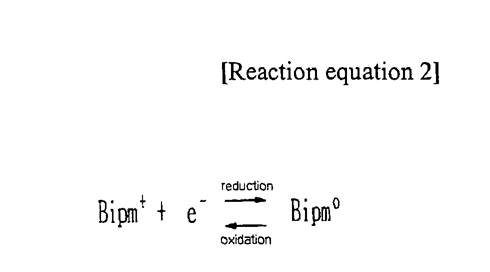

As can be seen from the following chemical equation 2, if the viologen is subjected to a predetermined relatively larger voltage, it reacts to change its color from a deep black to a light black. In the chemical equation 2, each of R₁ and R₂ indicates a phenyl group or alkyl group having 1 to 10 carbon atoms. Likewise, if an oxidation reaction is generated, the viologen changes its color from a light black to a deep black.

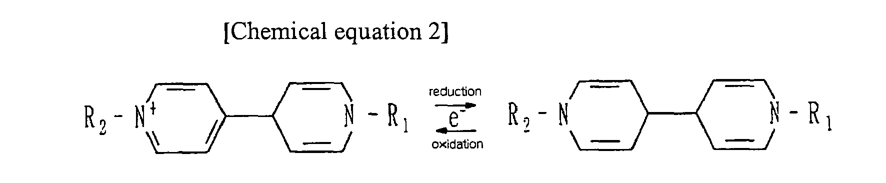

Consequently, if a larger voltage is applied between the first transparent electrode 616 and the second transparent electrode 617, when a reduction reaction is generated in the electrochromic layer, the electrochromic layer changes its color from a deep black to a light black to indicate gray tone. Also, when an oxidation reaction is generated in the electrochromic layer, the electrochromic layer changes its color from a light black to a deep black to make front side emission.

As another example, reaction equation 3 below is an anode compound reaction equation of metallocene. In the reaction equation 3, M indicates a metal.

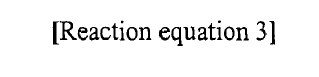

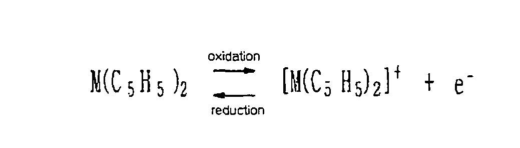

As described above, the coloring agent 619 of the electrochromic layer may include many substances such as an aromatic amine, an oxidation reduction complex, phtalocyanine, a heterocyclic compound, fluoran, styryl, anthraquinone, or phtalicdiester, etc. The electrolyte 418 may include aqueous or non-aqueous liquid (electrolyte) and semi-solid (high polymer electrolyte), etc.

The organic light emitting display according to the present invention consequently controls the voltage applied to the electrochromic layer, enabling it to freely display an image on the basis of front emission or double-sided emission.

An organic light emitting display according to the present invention may be further provided with an optical sensor or a voice sensor, enabling it to freely display an image in response to light or voice.

In above-described embodiments, the TFT and the aperture overlap each other. However, the TFT and the aperture need not overlap each other. Also, in relation to the above-described embodiments, a coplanar TFT has been described. However, the present invention can be applied to a reverse coplanar structure, a staggered structure, and a reverse staggered structure.

As described above, the present invention relates to a flat panel display and an organic light emitting display which can maintain an opaque state when required, while maintaining a transparent state at other times. This is achieved by providing a transparent double-sided emission panel and a controlling unit on the lower portion of the transparent double-sided emission panel, thereby enabling it freely to display an image on one or two sides and also improve image luminance.

Although preferred embodiments of the present invention have been disclosed for illustrative purposes, those skilled in the art will appreciate that various modifications, additions and substitutions are possible, without departing from the scope of the invention as defined in the accompanying claims.

## Claims

1. A flat panel display (FPD) comprising:
an at least partly transparent and double-sided emission panel; and
a controlling unit provided on at least one side of the emission panel;
wherein the controlling unit comprises a liquid crystal layer and first and second polarizing members and controls the transmission of light therethrough on the basis of a voltage applied to the liquid crystal layer.

2. A FPD as claimed in claim 1, wherein:
the first polarizing member is located on a side of the emission panel;
a first substrate is located on the first polarizing member;
a first transparent electrode is located on the first substrate;
the liquid crystal layer is located on the first transparent electrode;
a second transparent electrode is located on the liquid crystal layer;
a second substrate is located on the second transparent electrode; and
the second polarizing member is located on a lower portion of the second substrate.

3. A FPD as claimed in claim 2, further comprising a controller for applying a voltage to the first transparent electrode or the second transparent electrode.

4. A FPD according to any preceding claim, wherein the liquid crystal layer is an array of liquid crystal layers.

5. An organic light emitting display (OLED) comprising:
an organic light emitting display unit including at least one organic light emitting element formed on one side of a transparent substrate; and
a controlling unit formed on the other side of the organic light emitting display unit to control intensity of light emitted from the organic light emitting display unit;
wherein the controlling unit comprises aliquid crystal layer and first and second polarizing members and controls the transmission of light therethrough on the basis of a voltage applied to the liquid crystal layer.

6. An OLED as claimed in claim 5, wherein:
the first polarizing member is located on a side of the organic light emitting element;
a first substrate is located on the first polarizing member;
a first transparent electrode is located on the first substrate;
the liquid crystal layer is located on the first transparent electrode;
a second transparent electrode is located on the liquid crystal layer;
a second substrate is located on the second transparent electrode; and
the second polarizing member is located on a lower portion of the second substrate.

7. An OLED as claimed in claim 6, further comprising a controller for applying a voltage to the first transparent electrode or the second transparent electrode.

8. An OLED as claimed in claim 7, wherein the controller is manually driven.

9. An OLED as claimed in claim 7, wherein the controller is automatically controlled depending on intensity of external light.

10. An OLED as claimed in one of claims 5 to 9, wherein the organic light emitting display unit includes at least one transparent thin film transistor for driving the organic light emitting element.

11. An OLED as claimed in claim 10, wherein the transparent thin film transistor includes a transparent semiconductor layer, a gate electrode and source/drain electrodes, which are formed on the transparent substrate.

12. An OLED as claimed in claim 10, wherein the transparent semiconductor layer is formed of a wide band semiconductor substance having a band gap larger than 3.0eV.

13. An OLED as claimed in claim 12, wherein the transparent semiconductor layer is formed of: ZnO, ZnSnO, GaSnO, GaN or SiC.

14. An OLED as claimed in claim 11, 12 or 13 wherein the gate electrode and the source/drain electrodes are transparent.

15. An OLED as claimed in claim 14, wherein the gate electrode and source/drain electrodes are each formed of at least one respective material selected from a group comprising: indium tin oxide (ITO), indium zinc oxide (IZO), indium tin zinc oxide (ITZO) and translucent metals.

16. An OLED according to any one of claims 5 to 15, wherein the liquid crystal layer is an array of liquid crystal layers.
